# EUROPEAN PATENT APPLICATION

(11) **EP 2 626 884 A1**
(43) Date of publication of application: **14.08.2013**
(21) Application number: 12154905.9
(22) Date of filing: 10.02.2012
(51) Int. Cl.: H01J 37/20, H01J 37/26, G01N 23/04

(54) **Microfluidic chip for high resolution transmission electron microscopy**

(71) Applicant: Danmarks Tekniske Universitet - DTU, 2800 Kongens Lyngby (DK)
(72) Inventor: Mølhave, Kristian, 2820 Gentofte (DK); Jensen, Eric, 2840 Holte (DK)
(74) Representative: Pálsson, Ingólfur

(57) **Abstract**

A Microfluidic chip (100) for transmission electron microscopy has a monolithic body (101) with a front side (102) and a back side (103). The monolithic body (101) comprises an opening (104) on the back side (103) extending in a vertical direction from the back side (103) to a membrane (107) on the front side (102), the membrane (107) being supported at edges (106) of the opening (104) and extending across the opening (104), and a microfluidic channel (110, 610, 710a/b) comprising on top of the membrane (107) a sample chamber (113, 413, 713) with a top window (117, 417, 717) towards the front side (102) and a bottom window (116, 416, 716) towards the back side (103), the top and bottom windows (117, 417, 717 / 116, 416, 716) being aligned with each other so as to allow for observation of a sample volume between the top and bottom windows (117, 417, 717 / 116, 416, 716) inside the sample chamber (113, 413, 713) in a transmission configuration along an axial direction (EO), wherein the dimension of the membrane (107) in at least one horizontal direction exceeds the dimension of the sample chamber (113, 413, 713) in that direction.

## Description

The invention relates to a microfluidic chip for high resolution transmission electron microscopy. According to a further aspect, the invention relates to a method of providing a microfluidic chip for high resolution transmission electron microscopy.

Electron microscopy is an important research and analysis tool in the field of nanotechnology, due to the high resolution of the images that may be achieved using electron optics. Nowadays electron microscopes may achieve nanometre scale resolution, i.e. capable of resolving features that are about or below 10 nm apart, or even sub-nanometre resolution, i.e. capable of resolving features that are about or below 1 nm apart and down to about 0.1 nm. Transmission electron microscopes may even achieve sub-Ångstrøm scale resolution, i.e. capable of resolving features that are about or below 0.1 nm apart. The highest resolution achieved by transmission electron microscopy (TEM), involves very careful sample preparation and fine tuning of the electron imaging system when illuminating/probing the sample with electrons, during interaction of the electrons with the sample, and for detecting the electrons in an imaging device. However, electron propagation, deflection and focussing have to be done under vacuum conditions. Therefore it is very challenging to investigate fluid samples at sub-nanometre resolution, such as for studying complex liquids, surface reactions, living cells, or any other sample that requires the presence of a liquid or gaseous fluid interacting with the electron beam inside the electron microscope.

Common sample holders for fluids often have the draw back that the sample chambers are very bulky. Such sample holders often have large sample volumes with a large sample thickness in the direction of the incoming/probing electron beam and/or are equipped with very thick windows, both of which strongly affect the maximum resolution that can be achieved, or even are inhibitive to any high resolution imaging. In particular, TEM-imaging is very sensitive to the requirement of presenting a thin specimen to the electron beam, which in the case of fluid samples includes both the fluid sample itself and the windows defining a sample chamber on either side of the fluid sample as seen in the direction of the electron beam. A window may thus be defined as a layer, which is transparent to the electron beam to such a degree that a predetermined resolution may be obtained. A window for high resolution electron microscopy should thus at least be transparent to such a degree that nanometre scale resolution may be obtained. When decreasing the window thickness in order to improve transparency and achieve better resolution, another problem arises, namely that the window bulges outwardly as seen from the sample chamber, as the relative pressure of the fluid sample inside the sample chamber is increased and exceeds the vacuum pressure of the electron microscope. Such bulging again affects the maximum achievable resolution and may even lead to a catastrophic failure of the window resulting in a loss of the sample, and contamination of the microscope.

A microreactor suited for high-resolution TEM on a fluid sample is disclosed in EP 1 803 141. However, the micro reactor disclosed by the teaching of EP 1 803 141 has the draw back that it involves a delicate assembly process of at least two microfabricated parts. A device made of multiple separate parts requires individual handling, alignment, connection and fixation of these parts with respect to each other, which may be costly and/or difficult to control in respect of critical dimensions, e.g. of the actual height of the sample chamber.

The object of the present invention is to provide a microfluidic chip for performing transmission electron microscopy on a fluid sample, which overcomes at least some of the above mentioned draw-backs or provides an alternative. According to a further aspect, it is desirable to provide a microfluidic chip for performing transmission electron microscopy on a fluid sample, under higher pressures than the electron microscope vacuum, or even higher pressures than ambient pressures, wherein the fluid may be liquids and/or gasses.

According to one aspect, the object is achieved by a microfluidic chip for transmission electron microscopy, most preferably for high resolution transmission electron microscopy, the microfluidic chip having a monolithic body with a front side and a back side, the monolithic body comprising
- an opening on the back side extending in a vertical direction from the back side to a membrane on the front side, the membrane being supported at edges of the opening and extending across the opening, and
- a microfluidic channel comprising on top of the membrane a sample chamber with a top window towards the front side and a bottom window towards the back side, the top and bottom windows being aligned with each other so as to allow for observation of a sample volume between the top and bottom windows inside the sample chamber in a transmission configuration along an axial direction, wherein the dimension of the membrane in at least one horizontal direction exceeds the dimension of the sample chamber in that direction.

Microfluidic devices according to the present invention are micro-fabricated on or from planar substrates, typically semiconductor wafer substrates. The term "horizontal" refers to directions parallel to the plane defined by the planar substrate ("in-plane"), the term "vertical" refers to directions perpendicular to the plane of the planar substrate, and directions comprising at least a non-vanishing vertical component are referred to as "out-of-plane". In the context of this application, a first or front side defines the top of the substrate and of the microfluidic chip fabricated from it, and a second or back side defines the bottom of the substrate and of the microfluidic chip fabricated from it. Accordingly, the general terms "top" and "bottom" or "above" and "below" are defined in the vertical direction, wherein an upward direction points from the back side to the front side of the substrate and a downward direction points from the front side to the back side of the substrate. Directions along a microfluidic channel, i.e. in the principal direction of flow when a fluid is passed to through the channel is referred to as "longitudinal" directions and directions perpendicular to the longitudinal direction are referred to as "transverse" directions. since the microfluidic channels are defined in/on the planar substrate. Two particular transverse directions may be referred to as the "transverse horizontal" direction and the "transverse vertical" direction according to their in-plane and vertical orientation with respect to the planar substrate, respectively.

Fabricating the microfluidic device using known micro-fabrication techniques, such as known semiconductor processing techniques, makes it possible to produce the structures and features of the device at the required scale and dimensions, while at the same time benefiting from the advantages of simultaneously producing numerous devices at a time, thereby reducing cost.

Limitation to a monolithic design instructs the skilled person to produce the device from a single substrate/wafer, using micro-fabrication techniques not involving any assembly or manipulation of multiple parts, e.g. by pattern transfer and micro-machining. Thereby, yield and precision of the production is increased, as well as control and reproducibility of critical dimensions within the microfluidic device is improved, such as for obtaining precise dimensions of the sample chamber, channels, and/or window layers. The limitation to a monolithic design thereby improves the fabrication process and its precision as required for the highest resolution performance when performing TEM on fluid samples. By requiring the microfluidic chip for TEM to have a monolithic body, the advantages of microfabrication/semiconductor processing in terms of high precision and low cost are put into effect.

The recess opening on the backside of the body of the microfluidic chip extends all the way to the front side, only leaving a thin membrane of the first layer, which carries the sample chamber. This design allows for electron beam access to the sample chamber from both sides, so as to align the sample volume such that the optical axis of the electron beam defining the axial direction passes through the sample volume in an essentially vertical or at least out-of-plane direction. The cross-section of the opening in a horizontal cut plane may have any shape, such as rectangular; oval, diamond shaped, or even cross-shaped, as long as the opening provides access of the electron beam to the sample chamber.

The relatively thin membrane supports the microfluidic channel comprising the fluid sample chamber. Since the relatively thin membrane (as compared to the substrate thickness) in a horizontal direction is wider than the sample chamber in that direction, the membrane acts to isolate the sample chamber/channel from the bulk of the chip's body, thereby facilitating a good thermal and/or galvanic control of the sample volume. At the same time, the membrane provides a platform for easy addition of micro-fabricated accessory devices for measuring and controlling the physical conditions inside the sample chamber, such as heaters, electro-stimulation electrodes, grounding-electrodes, temperature sensors, strain gauges and the associated electrical leads required for operating any of the accessory devices.

In the horizontal plane, the sample chamber may essentially have any shape, and is preferably via the microfluidic channel comprising the sample chamber connected to an inlet and/or outlet for filling and draining the sample chamber. According to one embodiment, the sample chamber may be a section of a microfluidic channel located on top of the membrane, wherein the sample volume in a longitudinal direction along the channel may be delimited dynamically, e.g. by interfaces to immiscible fluids arranged upstream and downstream of the channel. In a transverse horizontal direction, the sample chamber is defined by side walls. In a transverse vertical direction, the sample chamber is defined by the top and bottom walls. According to one embodiment, the sample chamber may be split into diverging or converging sub-channels.

Advantageously, the first layer may also form the bottom wall of the sample chamber and the microfluidic channel, thereby simplifying the layer structure required for producing the microfluidic chip.

Preferably, the membrane dimension in a horizontal direction transversely of a micro-fluidic channel comprising the sample chamber is larger than the dimension of the microfluidic channel in that direction. Accordingly, the membrane dimension in a horizontal direction is larger than the sample chamber in a transverse direction of an elongated microfluidic channel comprising the sample chamber.

A top wall thickness may have a thickness of the order of several hundreds of nanometres, and typically is at least or about 250nm. Such a wall thickness is not suited for high resolution transmission electron microscopy. Accordingly, typical bottom wall thicknesses of at least several hundreds of nanometres are inhibitive to high resolution electron microscopy. Therefore window regions are provided in the top and bottom walls of the sample chamber, where the walls are made sufficiently transparent for an electron beam to not affect the maximum achievable resolution of the electron microscope significantly, or at least to not deteriorate the electron beam so much that high resolution imaging at nanometre scale or preferably sub-nanometre scale is not possible anymore. The maximum achievable resolution for a given window thickness may be determined e.g. by resolution measurements obtained on a resolution reference sample in the absence of any fluid sample through windows made of the same material and of the respective thickness.

Further, according to one embodiment of a microfluidic chip according to the invention, a window thickness of the top window and/or the bottom window is less than or about 100 nm, alternatively less than or about 50 nm, alternatively less than or about 20 nm, or about 10 nm.

When performing TEM on a fluid sample enclosed between the top and bottom windows, the interaction of the electron beam with the window material contributes to the spreading of the electrons, thus affecting the maximum resolution that may be achieved for studying the actual sample. In order to achieve the highest resolution performance, the thickness of each of the windows should not exceed 100 nm, preferably less than 20nm, or even below.

Advantageously according to one embodiment of the invention, the windows are made of the channel wall material, e.g. by thinning down the channel wall in an area where a window is desired. The thinning may be made by any known micro-machining technique, such as wet etch, dry etch, ion beam milling, or the like.

Advantageously according to another embodiment, the windows can be made from other materials than the material defining the remaining channel wall, e.g. conductive materials and/or high-strength atomically thin layers, such as graphene. Windows made from other materials can be provided both during and after the fabrication sequence of the microfluidic chip. During fabrication, thin layers of the other materials can be coated into the membrane and/or channel wall material, and the membrane sacrificially etched in the window region. After the microfluidic chip with the channel has been fabricated, apart from providing the windows, holes can be made in the top wall, bottom wall or in both the top and bottom walls of the channel, and then a thin film structure can be applied to cover the window region and seal the channel using a known process for transferring thin solid films to a surface. Examples of suitable processes for transferring thin solid films may be found in the relevant scientific literature. For instance, graphene can be transferred to a surface as disclosed in an article by Yung-Chang Lin et al.,"Clean Transfer of Graphene for Isolation and Suspension", ACS Nano, 2011, 5 (3), pp 2362-2368 (http://pubs.acs.org/doi/pdfplus/10.1021/nn200105j), or thin films such as solid carbon films floating on a water surface can be transferred onto a surface as described by David Stokes in "http://cryoem.nysbc.org/protoc-grids-SCF.html".

Further, according to one embodiment of a microfluidic chip according to the invention, the top window and the bottom window in a vertical direction are spaced apart from each other at a distance of less than 1 µm.

Reducing the interaction length of the electron beam with the sample increases the maximum resolution that may be achieved in TEM. In the case of a fluid sample retained between two windows, the interaction length is given by the sample thickness measured along the axial direction including the top window, the bottom window, and the height of the sample volume in the region of the windows. Preferably, the total sample thickness including the thickness of the top and bottom windows should be less than or about 1 µm in order to achieve the highest resolution performance, such as sub-nanometre resolution.

As mentioned above, a further issue affecting TEM resolution is the bulging of the sample chamber in the region of the windows, when the pressure inside the sample chamber exceeds the vacuum pressure inside the electron microscope. These pressures may differ by several orders of magnitude. For example, the sample space of the electron microscope may be operated at high vacuum, i.e. below 100 mPa, whereas it may be desirable or even necessary to keep the fluid sample inside the sample chamber of the microfluidic chip at about ambient pressures, e.g. above 100 hPa, or even higher pressures, such as 1 MPa, thus differing by five orders of magnitude or more. According to one approach, the bulging may be reduced by reducing the channel width, and thus by keeping the minimum horizontal dimension to be spanned by the window below a critical value for a given operational pressure difference between the inside and the outside of the sample chamber.

Advantageously according to one embodiment of a microfluidic chip, a transverse horizontal dimension of the sample chamber is less than 1µm.

Further, according to one embodiment of a microfluidic chip according to the invention, the sample volume inside the sample chamber comprises one or more pillars providing a mechanical connection between the top and bottom window, said mechanical connection providing tensile strength in at least a vertical direction.

The mechanical connection is configured to at least counter/withstand/provide strength against tensile forces in essentially vertical directions resulting from the windows bulging outwardly from the sample volume due to the overpressure inside the sample chamber as compared to the surrounding vacuum environment inside the electron microscope. If a plurality of columns is provided they are in horizontal directions interspaced with respect to each other, typically in an evenly spaced distribution.

The columns may be combined with the above-mentioned approach of reducing the window size to reduce bulging, or may be applied alternatively thereto. This embodiment is particularly advantageous when a large field of view is desired, yet requiring very thin windows, e.g. if high resolution electron microscopy is to be combined with optical microscopy on the same sample and through the same windows. The pillars are arranged inside the sample chamber and establish a mechanical connection between the windows with tensile strength in a vertical or at least essentially vertical direction, thereby preventing or at least counteracting an outward bulging of the windows with respect to the sample volume. Preferably, the pillars are vertical structures or essentially vertical structures, i.e. structures that are elongated and oriented in an essentially vertical direction.

Further, according to one embodiment of a microfluidic chip according to the invention, the microfluidic chip further comprises electrodes in thermal, capacitive and/or galvanic contact with the inside of the microfluidic channel and/or the sample chamber.

By providing electrodes, the chip may be equipped with means for controlling temperature and/or current/voltage and/or electrostatic/electrochemical potential. Due to the monolithic design of the chip where the microfluidic channel and the sample chamber are arranged on top of membrane, the microfluidic channel and the sample chamber are easily accessible from the top side for further micro-fabrication steps for adding any such accessory devices. Due to the thin membrane support, the sample chamber is effectively isolated from the bulk substrate, thus allowing for an improved control of physical parameters, such as temperature and/or the galvanic environment of the sample chamber by means of the electrodes.

Further, according to one embodiment of a microfluidic chip according to the invention, the microfluidic chip further comprises sensors for measuring temperature, electrical field, voltage, current, magnetic field, strain and/or pressure.

As mentioned above, the membrane may act as a carrier/platform for adding (thin) electrically conductive leads, essentially without compromising the thermal insulation. These leads may be used both directly as electrodes and resistive heater elements and/or may be combined with sensor structures provided in connection with the sample chamber and/or the microfluidic channel. The sensor structures may be provided inside and/or in the vicinity of the sample chamber and/or the microfluidic channel.

Further, according to an advantageous embodiment of a microfluidic chip according to the invention, at least one of the windows comprises a strain gauge for measuring elongations and/or bending due to any bulging deformation of the window.

By providing a strain gauge directly at the window, e.g. by including a piezo-resistive material configured as a strain gauge and in electrical contact with measurement electrodes for measuring resistance and/or current/voltage characteristics of the strain gauge allows determining the deformation of the window, e.g. when applying an overpressure inside the sample chamber as compared to the environment on the outside of the sample chamber, thereby providing a measure for the pressure directly at the location of a fluid sample inside the sample volume. A deformation measurement may also be used e.g. for triggering an alarm to prevent excessive deformation beyond a safety limit to avoid rupture of the window. Alternatively or in addition thereto, such deformation measure may be also be used to determine the actual sample thickness in-situ. Further, according to one embodiment of a microfluidic chip according to the invention, one or more stiffening members are arranged on top of the membrane layer and extending across the membrane.

Thereby a stiffening of the membrane may be achieved without compromising the thermal and/or galvanic isolation advantage achieved by the thin membrane support. Advantageously, the stiffening members are elongated beams arranged in the plane of the membrane. Advantageously, a plurality of stiffening members may be arranged in parallel to each other, and preferably transversely of a microfluidic channel running across the membrane. Alternatively, a plurality of stiffening members may be arranged to form a grid like support structure. The stiffening members may also act to transfer heat from heating elements to the channel.

Further, according to one embodiment of a microfluidic chip according to the invention, the membrane comprises a reference aperture arranged in the vicinity of the sample chamber and outside thereof.

A small aperture perforating the membrane in the vicinity of the sample chamber may be advantageous for passing a reference beam, such as for measuring/calibrating beam intensity and/or for performing e-beam holography. In the case of e-beam holography, the reference window should be arranged so as to be able to maintain coherence between a reference beam passing through the reference window and an object beam passing through the sample volume, i.e. typically in close vicinity of the sample chamber.

According to a further aspect of the invention, the object of the invention is achieved by a method of producing a micro-fluidic chip for transmission electron microscopy, most preferably for high resolution transmission electron microscopy, the method comprising the steps of
- providing a planar substrate having a front side and a back side,
- depositing a first layer of a membrane material on the front side,
- above the first layer, depositing a second layer of a sacrificial material,
- defining a microfluidic channel layout in the second layer by means of pattern transfer and etching, the microfluidic channel layout comprising a sample chamber portion,
- overgrowing the layout with a third layer of a channel wall material,
- providing a number of orifices in the third layer perforating the channel wall material to provide access to the sacrificial material,
- removing the sacrificial material through the orifices by applying a selective etch so as to form microfluidic channels comprising a sample chamber according to the layout, wherein at least side walls and a top wall are defined by the channel wall material,
- etching an opening through the substrate from the back side, the opening extending from the back side to the first layer at the front side, thereby leaving a membrane being supported at edges of the opening and extending across the opening,
- the membrane being in horizontal directions aligned with the microfluidic channels so as to comprise in a vertical projection the sample chamber within the edges of the membrane, wherein the dimension of the membrane in at least one horizontal direction exceeds the dimension of the sample chamber in that direction,
- providing a top window in the top wall to the sample chamber and providing a bottom window in the bottom wall of the sample chamber, wherein the top and bottom windows are aligned with each other so as to allow for observation of a sample volume between the top and bottom windows inside the sample chamber in a transmission configuration along an axial direction,

Advantageously, a method of providing a microfluidic chip comprises the further steps of providing inlet and/or outlet ports in fluid connection with the microfluidic channels, and/or dicing the planar substrate to obtain one or more chips fabricated in parallel on/from a larger substrate comprising a plurality of similar chips.

Advantageously, bottom walls of the microfluidic channel are defined by the membrane layer material, wherein the membrane layer and the channel walls may be made of the same material. The interior of the channels is carved out by using a selective etchant, wherein the etchant selectively attacks the sacrificial material, but not the channel wall material. A suitable choice for the channel material is for example SiN with for instance poly-silicon as a sacrificial material. However, other material choices are possible, as long as the channel wall material has a compatible sacrificial material allowing for removing the sacrificial material by a selective etch. Advantageously according to another embodiment, the channel walls are made of an electrically conductive material, such as TiN or Si. Such a choice of the channel wall material allows for improving the possibilities for controlling the electrical potential of the fluid sample, e.g. by grounding of the channel wall material, so as to reduce or avoid charge build-up that may occur due to the interaction with the electron beam of the electron microscope. An efficient control/reduction of the charge build-up is advantageous, since charge build-up phenomena distort the electron imaging conditions, and thereby may seriously affect the resolution that can be achieved.

The opening on the back side may be removed by a bulk etch or by any known micro-fabrication/machining process allowing for the bulk removal of the substrate material, while leaving an edge suspended membrane.

As mentioned above, window regions are required in the top and bottom walls of the sample chamber, in order to allow a focussed electron beam of an electron microscope to pass through the sample volume and achieve high imaging resolution in a transmission configuration. Preferably, the windows are provided by thinning the top and bottom walls at least in selected regions. In case the membrane forms the bottom wall of the microfluidics channel in the region of the sample chamber, the bottom window may be provided by thinning the first layer at least in selected regions. In case the bottom wall of the sample chamber is formed by a different layer than the membrane, the membrane material should be removed in the region of the bottom window to allow the electron beam to pass unhindered. As mentioned above, advantageous window thicknesses are below 100nm, preferably below 50nm, preferably below 20nm, and further preferably below 10nm.

Further, according to one embodiment of a method of producing a microfluidic chip, the channel layout comprises lateral projections extending in a transverse horizontal direction with respect to a longitudinal channel axis, wherein the orifices in the channel wall material are provided in the region of the lateral projections.

After patterning the sacrificial layer according to the channel layout, and after overgrowth of the channel layout with a channel wall material, such as SiN, the access orifices for etching the sacrificial material away are defined in the region of the lateral projections. Preferably, the orifices are arranged on top of the lateral projections, thereby making it easier to access the inside of the channel by subsequent surface micro-fabrication techniques.

Further according to one embodiment, a method of producing a microfluidic chip further comprises, after performing the sacrificial etch, the step of sealing the orifices by depositing a sealing material.

Further, according to one embodiment of a method of producing a microfluidic chip, the sealing material is an electrically conductive material, preferably metal so as to provide electrical contact with the inside of the microfluidic channel.

Thereby electrodes may easily be provided in electrical contact with the inside of the microfluidic channel and/or sample chamber. Preferably the electrically conductive material is metal or has a metal like conductivity. Alternatively, the electrically conductive material may also comprise a doped semiconductor material. Electrical leads in contact with the electrically conductive sealing material may be provided and at least partially supported by the membrane. The electrical leads may be used for connecting the electrodes with any external control and/or measurement equipment, and/or for providing additional electronic circuitry on chip.

In the following, the invention is further explained referring to an exemplifying embodiment. The drawings show schematically on
- Fig. 1: a top elevational view of a microfluidic chip according to one embodiment,
- Fig. 2: a bottom elevational view of the microfluidic chip of Fig. 1,
- Fig. 3: a cross-sectional view of the microfluidic chip of Fig. 1 along line III-III,
- Fig. 4: a top elevational view of a sample chamber according to one embodiment,
- Fig. 5: a cross-sectional view of the sample chamber of Fig. 4 along line V-V,
- Fig. 6: a top elevational view of an electrode connected to a microfluidic channel according to one embodiment,
- Fig. 7: a top elevational view of a sample chamber comprising pillars, and
- Fig. 8: a cross-sectional view of the sample chamber of Fig. 7 along line VIII-VIII.

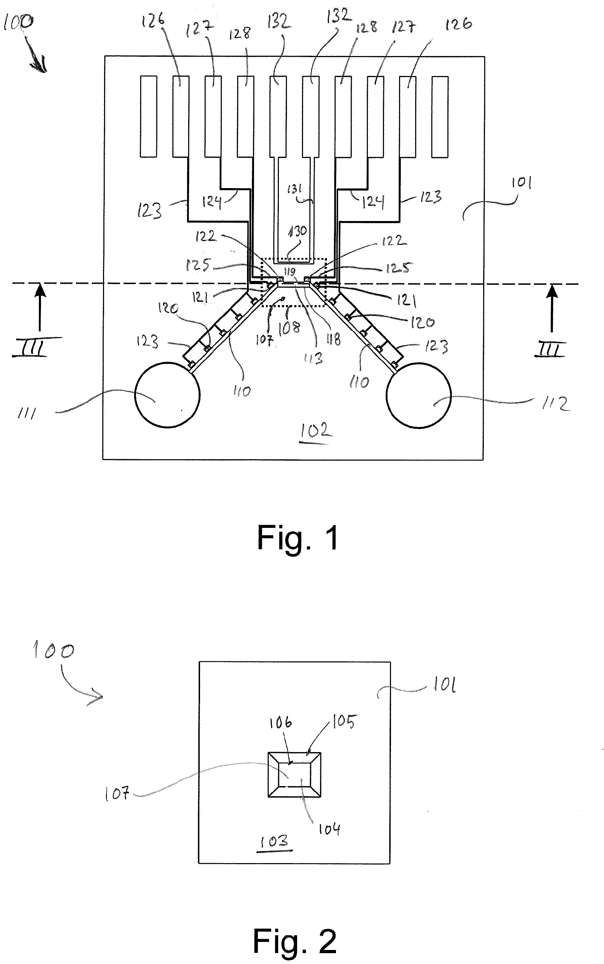

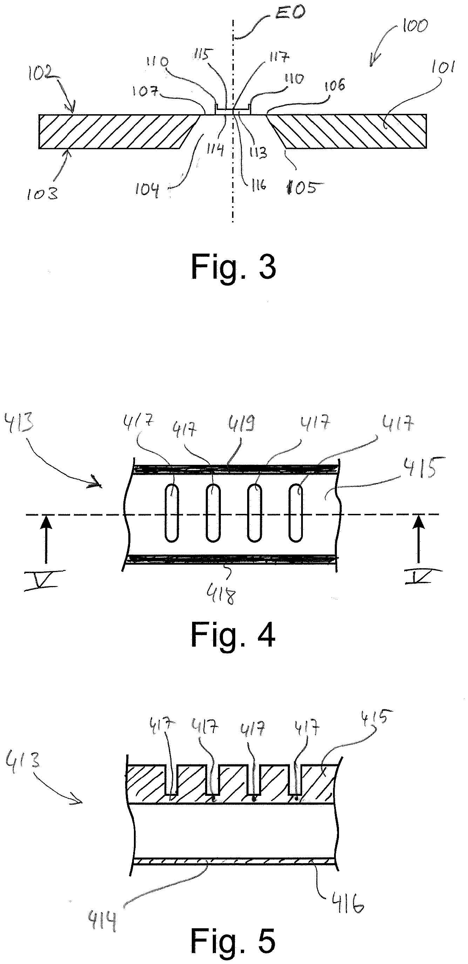

Fig. 1 shows the front side of one embodiment of a microfluidic chip 100 according to the invention, i.e. the microfluidic chip as seen from the top. Fig. 2 shows the back side of the same embodiment of the microfluidic chip 100, i.e. the microfluidic chip 100 as seen from the bottom. Fig. 3 shows a cross-section of that embodiment 100 along line III-III as indicated in Fig. 1, wherein for reasons of clarity only elements in the cut-plane are shown, and any accessory structures, such as electrodes, electrical leads, mechanical guards or the like have been omitted. Referring to Figs. 1-3, a microfluidic chip 100 has a monolithic body 101 with a front side 102 and a back side 103. The monolithic body 101 comprises an opening 104 provided on the back side 103 of the monolithic body 101. The opening 104 extends from lower edges 105 on the back side 103 to upper edges 106 at a membrane layer (not shown) on the front side 102. The opening is formed by removing bulk material from the body 101 of the microfluidic chip from the backside, e.g. using a KOH-based wet-etch or any other suitable bulk micromachining process, thereby releasing a membrane 107. The membrane 107 is part of the membrane layer and is suspended at the upper edges 106 of the opening 104 and extends across the opening 104. The upper edges 106 of the opening 104 thus define the contour 108 of the membrane 107 (dotted line in Fig. 1).

On the front side 102 of the body 101, the microfluidic chip 100 comprises a microfluidic channel 110 connected to an inlet 111 for feeding fluid to the microfluidic chip 100 and an outlet 112 for discharging fluid from the microfluidic chip 110. Due to the monolithic design of the body 101, the microfluidic channel 110 is provided by a sacrificial etching technique. The sacrificial etch comprises depositing a sacrificial layer e.g. of poly-silicon, then patterning that sacrificial layer to define a microfluidic channel layout, then overgrowing that layout with a channel wall material, such as SiN, and finally removing the sacrificial material through orifices in the channel wall material to form the microfluidic channel 110. On top of the membrane 107, the microfluidic channel 110 comprises a sample chamber 113, which in a transverse horizontal direction is defined by side walls 118, 119, and in a transverse vertical direction by a bottom wall 114 and a top wall 115. Being placed in the top portion of the microfluidic chip 100, the top of the sample chamber 113 is accessible from the front side, whereas the opening 104 forms a recess, through which the bottom of the sample chamber 113 is accessible from the back side.

The bottom wall 114 comprises a bottom window 116 towards the back side, the top wall 115 comprises a top window 117 towards the front side. The top and bottom windows 116, 117 are aligned with respect to each other such that a fluid sample inside the sample chamber 113 may be observed by electron microscopy in a transmission configuration along an axial direction defined by the electron optical axis EO as indicated by the dash-dotted line in Fig. 3. While the electron optical axis EO in Fig. 3 is shown to be vertical, i.e. perpendicular to a horizontal plane defined e.g. by the front side 102 of the planar body 101, the electron optical axis EO may also be inclined with respect to the microfluidic chip.

In at least one horizontal direction, the dimension of the membrane 107 exceeds the corresponding dimension of the sample chamber 113. Preferably, the membrane 107 is wider than the sample chamber 113 in a direction transverse to the microfluidic channel 110 in the region of the sample chamber 113. As can be seen from Fig. 1, the sample chamber 113 is for this preferred embodiment kept within the boundaries of the membrane contour 108. The cross-section along line III-III in Fig.1, which is shown in Fig. 3, is taken along the longitudinal axis of the microfluidic channel 110 in the region of the sample chamber 113. In the longitudinal horizontal direction, the sample chamber 113 is delimited by transition ends of feed and discharge portions of the microfluidic channel 110 and is shorter than the dimension of the membrane 107 in that longitudinal horizontal direction. That is, the dimension of the membrane 107 exceeds the dimensions of the sample chamber 113 in both the transverse horizontal direction and the longitudinal horizontal direction.

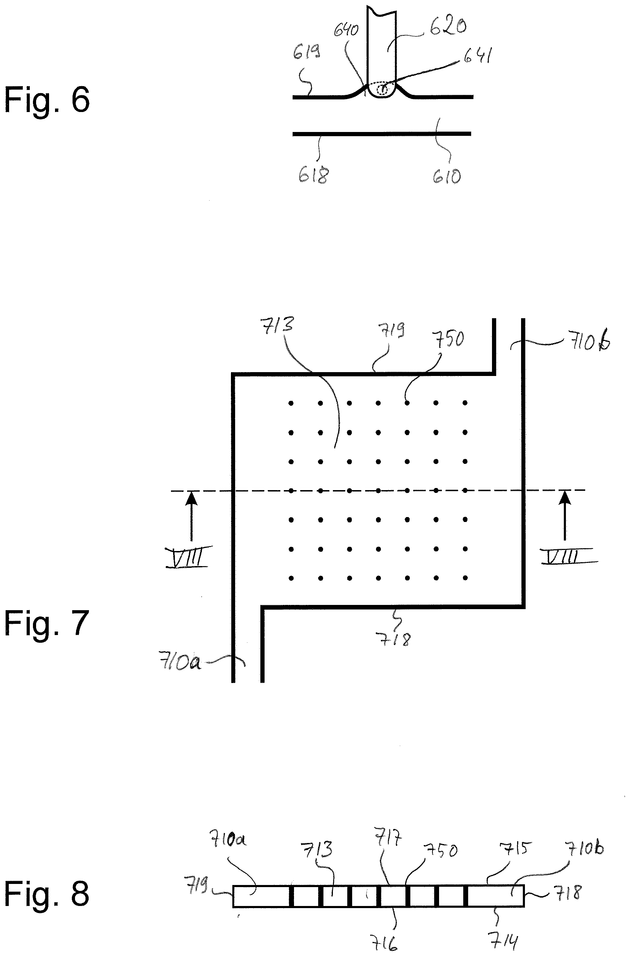

The microfluidic chip 100 may be provided with a number of accessory devices, some of which are shown by way of example in Fig. 1. Such accessory devices may include grounding electrodes 120 for discharging the fluid sample from any charge build-up that might occur, e.g. due to the absorption of electrons. The accessory devices may further include electrodes 121 arranged in the vicinity of the sample chamber 113, and/or electrodes 122 arranged to be in direct contact with the sample volume inside the sample chamber 113. Via electrical leads 123, 124, 125, the electrodes 120, 121, 122 may be addressed from contact pads 126, 127, 128. The electrodes 120, 121, 122 may be used for example to supply and/or read electrical, magnetic, or electromagnetic signals, e.g. in order to provide a stimulus to the sample, control sample conditions, and/or probe any electrically measurable quantities related to the sample or the sample chamber. According to some embodiments, the electrodes 120, 121, 122 may be configured to be in contact with the inside of the microfluidic channel 110/sample chamber 113, for instance by an advantageous electrode design as further detailed below with respect to Fig. 6. Alternatively or in addition thereto, the electrodes may be in contact with functional layers integrated in the sample chamber walls, such as heaters, temperatures sensors, and/or strain gauges (not shown). For example, a piezo-resistive material may be included in the top and/or bottom windows 116,117 as a strain gauge which may be contacted from the outside through contact pads, electrical leads and electrodes in contact with the strain gauge. A strain gauge integrated in the electron beam windows 116, 117 may be used for determining deformation of the windows 116, 117 and the corresponding pressure difference between the inside and the outside of the sample chamber 113 causing such deformation. Furthermore, the micro-fluidic chip 100 may include accessory devices located on the membrane 107, such as a resistive element 130, which may be used e.g. as a heater or for measuring temperature. Electrical contact to the resistive element 130 is provided through electrical leads 131 and contact pads 132. Due to the monolithic design of the body 101, the microfluidic channel 110, the sample chamber 113, and the membrane 107, which supports and isolates the sample chamber 113, are all located and accessible on the front side 102 of the chip, and accessory devices may therefore easily be fabricated on the front side 102 of the body 101 by additional surface micro-machining processing. Furthermore, also the membrane 107 itself provides a platform for additional processing, yet fulfilling an isolating function allowing for an improved in-situ control of physical conditions of the sample in an electron microscope, as compared to a design without a membrane 107 that is larger than the sample chamber 113 in the horizontal directions.

Fig. 4 shows schematically an embodiment of a sample chamber portion 413 of a microfluidic chip as seen from the top. Fig. 5 shows schematically the sample chamber portion 413 of Fig. 4 as seen in a longitudinal cross-sectional view along line V-V in Fig. 4. Referring to Figs. 4 and 5, the sample chamber 413 is in a transverse horizontal direction defined by sidewalls 418, 419, and in a transverse vertical direction defined by a bottom wall 414 and a top wall 415. Top windows 417 are provided in the top wall 415 by thinning selected regions of the top wall down to a window thickness allowing for passing an electron beam of an electron microscope through the window region without seriously affecting the maximum achievable resolution of the electron microscope. The embodiment shown has also a bottom window 416, which is transparent to electrons, but which has been obtained by thinning the bottom wall 414, e.g. formed by the membrane, over the whole area.

Fig. 6 shows schematically an advantageous design for providing electrodes that are in contact with the inside of a microfluidic channel 610 defined by sidewalls 618, 619. The layout of the microfluidic channel 610 comprises a lateral projection 640 in a transverse horizontal direction, where the sidewall 619 pouches outwardly as seen from the inside of the microfluidic channel 610 to form a lateral protuberance of the channel 610. An orifice 641 is provided to perforate the protuberance from the top. The orifice 641 may advantageously be used for removing any sacrificial material from the inside of the channel 610 during fabrication of the channel 610. After the sacrificial etching step, the orifice should be sealed. This may further advantageously be done by depositing a metal so as to provide an electrode 620 in electrical contact with the inside of the channel 610. The electrode design shown in Fig. 6 may be used for providing electrical contact to the inside of any portion of the microfluidic channel 610, i.e. also for a sample chamber.

Fig. 7 shows schematically a sample chamber according to a further embodiment of the invention as seen from the top. Fig. 8 shows the same embodiment in a longitudinal cross-section along line VIII-VIII in Fig. 7. Referring to Figs. 7 and 8, a sample chamber 713 is in horizontal directions defined by side walls 718, 719, and in a vertical direction by a bottom wall 714 and a top wall 715. The sample chamber 713 is connected to a feed portion 710a and a discharge portion 710b of a microfluidic channel for filling and removing a fluid sample to the sample chamber 713. The top and bottom walls 714, 715 are fabricated to be sufficiently thin so as to form windows 716, 717 that are transparent to electrons throughout essentially the whole area covered by the sample chamber 713, wherein the horizontal dimensions may be 100 x 100 micrometre^2 or more. Since the electron windows should not exceed 100nm in thickness, preferably be below 50nm, below 20nm, or even about 10nm, the inside of the sample chamber 713 comprises vertical pillars 750 distributed throughout the sample volume. The pillars provide a mechanical connection with tensile strength between the top and bottom walls 714, 715, thereby preventing or at least largely reducing any bulging out of the windows 716, 717. These pillars may advantageously be part of the microfluidic channel layout, and thus be fabricated from channel wall material in the same sacrificial processing step as forming the microfluidic channel comprising the sample chamber 713.

### Reference Numbers

- 100: microfluidic chip
- 101: monolithic body
- 102: front side
- 103: back side
- 104: opening
- 105, 106: edges of the opening
- 107: membrane
- 108: membrane contour
- 110, 610, 710a/b: microfluidic channel
- 111: inlet
- 112: outlet
- 113, 413, 713: sample chamber
- 114,414,714: bottom wall
- 115,415,715: top wall
- 116, 416, 716: bottom window
- 117,417,717: top window
- 118,418,618,718: side wall
- 119,419,619,719: side wall
- 120, 121, 122: electrodes
- 123, 124, 125, 131: electrical leads
- 126, 127, 128, 132: contact pads
- 130: resistive element
- 750: pillars (tensile strength elements)

## Claims

1. Microfluidic chip (100) for transmission electron microscopy, the microfluidic chip (100) having a monolithic body (101) with a front side (102) and a back side (103), the monolithic body (101) comprising
- an opening (104) on the back side (103) extending in a vertical direction from the back side (103) to a membrane (107) on the front side (102), the membrane (107) being supported at edges (106) of the opening (104) and extending across the opening (104), and
- a microfluidic channel (110, 610, 710a/b) comprising on top of the membrane (107) a sample chamber (113, 413, 713) with a top window (117, 417, 717) towards the front side (102) and a bottom window (116, 416, 716) towards the back side (103), the top and bottom windows (117, 417, 717 / 116, 416, 716) being aligned with each other so as to allow for observation of a sample volume between the top and bottom windows (117, 417, 717 / 116, 416, 716) inside the sample chamber (113, 413, 713) in a transmission configuration along an axial direction (EO), wherein the dimension of the membrane (107) in at least one horizontal direction exceeds the dimension of the sample chamber (113, 413, 713) in that direction.

2. Microfluidic chip according to any of the preceding claims, wherein a window thickness of the top window (117, 417, 717) and/or the bottom window (116, 416, 716) is less than or about 100 nm, alternatively less than or about 50 nm, alternatively less than or about 20 nm, or about 10 nm.

3. Microfluidic chip according to any of the preceding claims, wherein the top window (117, 417, 717) and the bottom window (116, 416, 716) in a vertical direction are spaced apart from each other at a distance of less than 1 µm.

4. Microfluidic chip according to any of the preceding claims, wherein the sample volume inside the sample chamber (713) comprises one or more pillars (750) providing a mechanical connection between the top and bottom window (717, 716), said mechanical connection providing tensile strength in at least a vertical direction.

5. Microfluidic chip according to any of the preceding claims, wherein the microfluidic chip further comprises electrodes (120, 121, 122, 620) in thermal, capacitive and/or galvanic contact with the inside of the microfluidic channel (110, 610, 710a/b) and/or the sample chamber (113, 413, 713).

6. Microfluidic chip according to any of the preceding claims, wherein the microfluidic chip further comprises sensors for measuring temperature, electrical field, voltage, current, magnetic field, strain and/or pressure.

7. Microfluidic chip according to any of the preceding claims, wherein at least one of the windows comprises a strain gauge for measuring elongations due to any bulging deformation of the window.

8. Microfluidic chip according to any of the preceding claims, wherein one or more stiffening members are arranged on top of the membrane layer and extending across the membrane.

9. Microfluidic chip according to any of the preceding claims, wherein the membrane comprises a reference aperture arranged in the vicinity of the sample chamber and outside thereof.

10. Method of producing a micro-fluidic chip (100) for transmission electron microscopy, the method comprising the steps of
- providing a planar substrate having a front side (102) and a back side (103),
- depositing a first layer of a membrane material on the front side (102),
- above the first layer, depositing a second layer of a sacrificial material,
- defining a microfluidic channel layout in the second layer by means of pattern transfer and etching, the microfluidic channel layout comprising a sample chamber portion,
- overgrowing the layout with a third layer of a channel wall material,
- providing a number of orifices in the third layer perforating the channel wall material to provide access to the sacrificial material,
- removing the sacrificial material through the orifices by applying a selective etch so as to form microfluidic channels (110, 610, 710a/b) comprising a sample chamber (113, 413, 713) according to the layout, wherein at least side walls (118, 418, 618, 718 / 119, 419, 619, 719) and a top wall (115, 415, 715) are defined by the channel wall material,
- etching an opening (104) through the substrate from the back side (103), the opening extending from the back side (103) to the first layer at the front side (102), thereby leaving a membrane (107) being supported at edges (106) of the opening (104) and extending across the opening (104),
- the membrane (107) being in horizontal directions aligned with the microfluidic channels (110, 610, 710a/b) so as to comprise in a vertical projection the sample chamber (113, 413, 713) within edges of the membrane, wherein the dimension of the membrane (107) in at least one horizontal direction exceeds the dimension of the sample chamber (113, 413, 713) in that direction,
- providing a top window (117, 417, 717) in the top wall (115, 415, 715) to the sample chamber (113, 413, 713) and providing a bottom window (116, 416, 716) in the bottom wall (114, 414, 714) of the sample chamber (113, 413, 713), wherein the top and bottom windows (117, 417, 717 / 116, 416, 716) are aligned with each other so as to allow for observation of a sample volume between the top and bottom windows (117, 417, 717 / 116, 416, 716) inside the sample chamber (113, 413, 713) in a transmission configuration along an axial direction (EO),

11. Method according to 10, wherein the microfluidic channel layout comprises lateral projections (640) extending in a transverse horizontal direction with respect to a longitudinal channel axis, wherein the orifices (641) in the channel wall material are provided in the region of the lateral projections (640).

12. Method according to any of the claims 10 or 11, after performing the sacrificial etch, further comprising the step of sealing the orifices (641) by depositing a sealing material.

13. Method according to claim 12, wherein the sealing material is an electrically conductive material, preferably a metal so as to provide electrical contact with the inside of the microfluidic channel.
